(19)

Europäisches Patentamt

European Patent Office

Office européen des brevets

(11) **EP 3 029 710 A1**

(12) **EUROPEAN PATENT APPLICATION**

(43) Date of publication:
08.06.2016 Bulletin 2016/23

(51) Int Cl.:
*H01J 37/147* (2006.01)　　　*H01J 37/28* (2006.01)

(21) Application number: 15197337.7

(22) Date of filing: 01.12.2015

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: 04.12.2014　JP 2014245592

(71) Applicant: **JEOL Ltd.**
**Akishima,**
**Tokyo 196-8558 (JP)**

(72) Inventor: **YAMADA, Mitsuru**
**Akishima, Tokyo (JP)**

(74) Representative: **Boult Wade Tennant**
**Verulam Gardens**
**70 Gray's Inn Road**
**London WC1X 8BT (GB)**

(54) **CHARGED PARTICLE BEAM DEVICE AND IMAGE ACQUISITION METHOD**

(57)　A charged particle beam device includes: an image displacement vector calculation section (60) that calculates an image displacement vector between a first local frame image and a second local frame image, the first local frame image including an area in a first frame image that is obtained by starting scanning at a timing that corresponds to a first phase of an alternating-current signal, and the area in the first frame image corresponds to a phase that undergoes a given phase shift from the first phase, and the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase; a scanning deflector (13) that scans a charged particle beam (B) while deflecting the charged particle beam (B); a scanning correction signal generation section (70) that generates a scanning correction signal that corrects the scanning of the charged particle beam (B) based on the image displacement vector; and a scanning signal supply section (20) that supplies a scanning signal that is corrected based on the scanning correction signal to the scanning deflector (13) in synchronization with the alternating-current signal.

EP 3 029 710 A1

**Description**

BACKGROUND OF THE INVENTION

The present invention relates to a charged particle beam device and an image acquisition method.

A charged particle beam device (e.g., a scanning electron microscope that is used to observe and analyze the microscopic structure of a living organism, a material, a semiconductor, or the like, and a critical dimension scanning electron microscope that is used to measure the dimensions of a semiconductor device circuit pattern) is known.

For example, a scanning electron microscope two-dimensionally scans an electron beam emitted from an electron source over a specimen (target) while narrowing down the electron beam, and detects secondary electrons, backscattered electrons, and the like generated from the specimen upon application of the electron beam to generate an image.

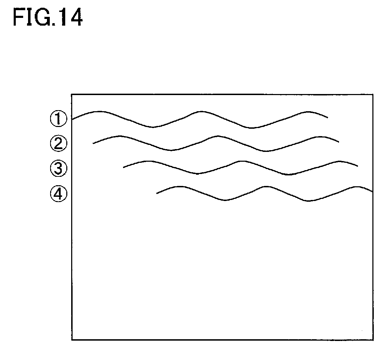

The optical column of such a scanning electron microscope is normally exposed to an external disturbance magnetic field that occurs due to the installation environment. Examples of the main component of the external disturbance magnetic field include an alternating-current magnetic field that occurs due to electrical wiring provided in a room in which the device is installed. The electron beam is deflected by the alternating-current magnetic field, and has a cyclically distorted shape (see FIG. 14) instead of the original linear shape. As a result, different parts of the image are distorted and undergo expansion and contraction in an irregular direction. Note that each line illustrated in FIG. 14 represents a scanning line, and each number illustrated in FIG. 14 is a number assigned to each scanning line.

For example, JP-A-2007-149348 discloses an electron microscope that is configured to reduce the effects of a magnetic field due to an AC power supply by synchronizing the two-dimensional scanning timing with the frequency phase of the AC power supply.

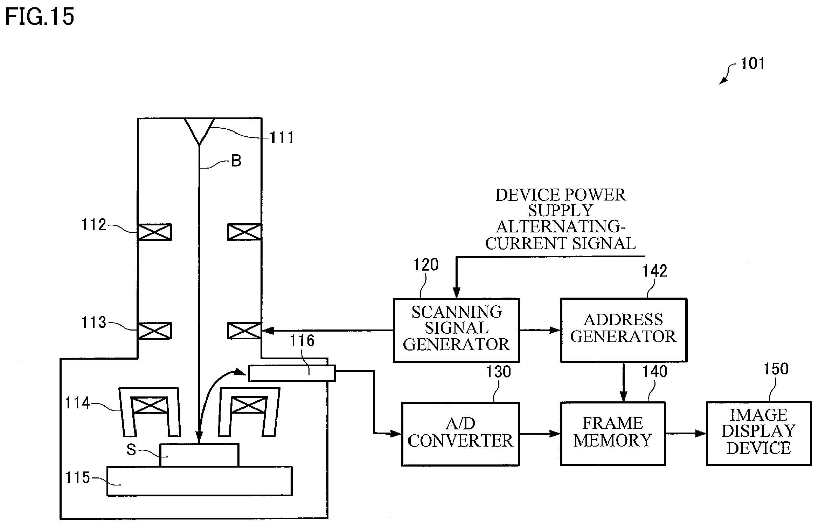

FIG. 15 is a view schematically illustrating the configuration of an electron microscope 101 that is an example of an existing charged particle beam device. As illustrated in FIG. 15, the electron microscope 101 includes an electron source 111, a condenser lens 112, a scanning deflector 113, an objective lens 114, a specimen stage 115, a detector 116, a scanning signal generator 120, an A/D converter 130, a frame memory 140, an address generator 142, and an image display device 150.

The electron microscope 101 is configured so that an electron beam B generated by the electron source 111 is narrowed down by the condenser lens 112 and the objective lens 114, deflected by the scanning deflector 113, and scanned over the surface of a specimen S that is supported by the specimen stage 115. Secondary electrons and the like generated by the specimen S are detected by the detector 116, and converted into an electrical signal. The electrical signal is converted into a digital signal by the A/D converter 130, stored in a memory pixel that is included in the frame memory 140 and has an address designated by the address generator 142 corresponding to the scanning signal, and displayed on the image display device 150.

The scanning signal generator 120 generates the scanning signal that has a sawtooth-like waveform, and drives the scanning deflector 113. The timing at which an image is stored in the frame memory 140 is synchronized with the scanning signal generated by the scanning signal generator 120.

The scanning signal generator 120 rasterscans the electron beam so as to draw each scanning line in synchronization with a device power supply alternating-current signal.

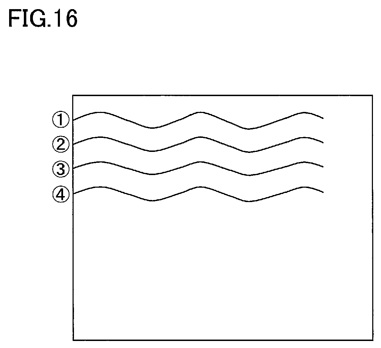

FIG. 16 is a view illustrating raster scanning that is synchronized with a power supply. The scanning of the electron beam that draws each scanning line is started from the same phase of the device power supply alternating-current signal. Therefore, the distortion of each scanning line due to the external disturbance magnetic field starts at the left end of the frame (see FIG. 16). Therefore, an image that does not undergo expansion and contraction in an irregular direction is obtained.

However, even when raster scanning is synchronized with the device power supply alternating-current signal, it is impossible to eliminate the distortion in which the image cyclically moves or undergoes expansion and contraction in the horizontal direction (see FIG. 16), for example.

SUMMARY

Several aspects of the invention may provide a charged particle beam device and an image acquisition method that make it possible to reduce cyclic distortion of an image caused by an external disturbance magnetic field.

According to a first aspect of the invention, there is provided a charged particle beam device that scans a charged particle beam in synchronization with an alternating-current signal, the charged particle beam device including:

an image displacement vector calculation section that calculates an image displacement vector between a first local frame image and a second local frame image, the first local frame image including an area in a first frame image that is obtained by starting scanning at a timing that corresponds to a first phase of the alternating-current signal, and the area in the first frame image corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
a scanning deflector that scans the charged particle beam while deflecting the charged particle beam;
a scanning correction signal generation section that generates a scanning correction signal that corrects the scanning of the charged particle beam based on the image displacement vector; and
a scanning signal supply section that supplies a scanning signal that is corrected based on the scanning correction signal to the scanning deflector in synchronization with the alternating-current signal.

According to a second aspect of the invention, there is provided a charged particle beam device that scans a charged particle beam in synchronization with an alternating-current signal, the charged particle beam device including: an image displacement vector calculation section that calculates an image displacement vector between a first local frame image and a second local frame image, the first local frame image including an area in a first frame image that is obtained by starting scanning at a timing that corresponds to a first phase of the alternating-current signal, and the area corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
a frame memory that includes a plurality of memory pixels;
an address correction signal generation section that generates an address correction signal that corrects an address of a memory pixel among the plurality of memory pixels based on the image displacement vector; and
an address selection section that corrects the address of the memory pixel based on the address correction signal, and stores a detection signal detected by a detector in the memory pixel that corresponds to the corrected address.

According to a third aspect of the invention, there is provided an image acquisition method that is implemented in a charged particle beam device that scans a charged particle beam in synchronization with an alternating-current signal, the image acquisition method including:

an image displacement vector calculation step that calculates an image displacement vector between a first local frame image and a second local frame image, the first local frame image including an area in a first frame image that is obtained by starting scanning at a timing that corresponds to a first phase of the alternating-current signal, and the area in the first frame image corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
a scanning correction signal generation step that generates a scanning correction signal that corrects the scanning of the charged particle beam based on the image displacement vector; and
a scanning signal supply step that supplies a scanning signal that is corrected based on the scanning correction signal to a scanning deflector in synchronization with the alternating-current signal.

According to a fourth aspect of the invention, there is provided an image acquisition method that is implemented in a charged particle beam device that scans a charged particle beam in synchronization with an alternating-current signal, the image acquisition method including:

an image displacement vector calculation step that calculates an image displacement vector between a first local frame image and a second local frame image, the first local frame image including an area in a first frame image that is obtained by starting scanning at a timing that corresponds to a first phase of the alternating-current signal, and the area in the first frame image corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
an address correction signal generation step that generates an address correction signal that corrects an address of a memory pixel included in a frame memory based on the image displacement vector; and
an address selection step that corrects the address of the memory pixel based on the address correction signal, and stores a detection signal detected by a detector in the memory pixel that corresponds to the corrected address.

BRIEF DESCRIPTION OF THE SEVERAL VIEWS OF THE DRAWING

FIG. 1 is a view schematically illustrating the configuration of an electron microscope according to a first embodiment.

FIG. 2 is a view illustrating an example of a scanning signal when raster scanning is started at a timing that corresponds to the phase 0° of a device power supply alternating-current signal.

FIG. 3 is a view illustrating an example of a scanning signal when raster scanning is started at a timing that corresponds to the phase 180° of a device power supply alternating-current signal.

FIG. 4A is a view schematically illustrating a frame image obtained by starting raster scanning at a timing that corresponds to the phase 0° of a device power supply alternating-current signal, and FIG. 4B is a view schematically illustrating a frame image obtained by starting raster scanning at a timing that corresponds to the phase 180° of the device power supply alternating-current signal.

FIG. 5A is a view schematically illustrating a first local frame image, and FIG. 5B is a view schematically illustrating a second local frame image.

FIG. 6 is a view illustrating a scanning correction signal.

FIG. 7 is a view illustrating an example of the results obtained by adding a scanning correction signal to a scanning signal.

FIG. 8 is a view illustrating an example of the results obtained by adding a scanning correction signal to a scanning signal.

FIG. 9 is a flowchart illustrating an example of an image acquisition method that is implemented using an electron microscope according to a first embodiment.

FIG. 10 is a view schematically illustrating the configuration of an electron microscope according to a second embodiment.

FIG. 11 is a view schematically illustrating the configuration of an electron microscope according to a third embodiment.

FIG. 12A is a view illustrating the state of a frame memory before the address is corrected, and FIG. 12B is a view illustrating the state of the frame memory after the address has been corrected.

FIG. 13 is a flowchart illustrating an example of an image acquisition method that is implemented using an electron microscope according to a third embodiment.

FIG. 14 is a view illustrating raster scanning that is not synchronized with a power supply.

FIG. 15 is a view schematically illustrating the configuration of a related-art electron microscope.

FIG. 16 is a view illustrating raster scanning that is synchronized with a power supply.

DETAILED DESCRIPTION OF THE EMBODIMENT

(1) According to one embodiment of the invention, a charged particle beam device scans a charged particle beam in synchronization with an alternating-current signal, the charged particle beam device including:

an image displacement vector calculation section that calculates an image displacement vector between a first local frame image and a second local frame image, the first local frame image including an area in a first frame image that is obtained by starting scanning at a timing that corresponds to a first phase of the alternating-current signal, and the area in the first frame image corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
a scanning deflector that scans the charged particle beam while deflecting the charged particle beam;
a scanning correction signal generation section that generates a scanning correction signal that corrects the scanning of the charged particle beam based on the image displacement vector; and
a scanning signal supply section that supplies a scanning signal that is corrected based on the scanning correction signal to the scanning deflector in synchronization with the alternating-current signal.

The charged particle beam device can scan the charged particle beam while deflecting the charged particle beam so as to cancel the external disturbance magnetic field, by correcting the scanning signal based on the scanning correction signal. This makes it possible to reduce the cyclic distortion of the image that is caused by the external disturbance magnetic field and synchronized with the device power supply cycle, and acquire an accurate image for which the distortion is reduced. The charged particle beam device can thus implement accurate observation and analysis.

(2) According to another embodiment of the invention, a charged particle beam device scans a charged particle beam in synchronization with an alternating-current signal, the charged particle beam device including:

an image displacement vector calculation section that calculates an image displacement vector between a first local frame image and a second local frame image, the first local frame image including an area in a first frame image that is obtained by starting scanning at a timing that corresponds to a first phase of the alternating-current signal, and the area corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
a frame memory that includes a plurality of memory pixels;
an address correction signal generation section that generates an address correction signal that corrects an address of a memory pixel among the plurality of memory pixels based on the image displacement vector; and
an address selection section that corrects the address of the memory pixel based on the address correction signal, and stores a detection signal detected by a detector in the memory pixel that corresponds to the corrected address.

The charged particle beam device can correct the address of the memory pixel included in the frame memory based on the address correction signal, so that the scanning position of the charged particle beam deflected by the external disturbance magnetic field corresponds to the address of the memory pixel. This makes it possible to reduce the cyclic distortion of the image that is caused by the external disturbance magnetic field and synchronized with the device power supply cycle, and acquire an accurate image for which the distortion is reduced. The charged particle beam device can thus implement accurate observation and analysis.
(3) In the charged particle beam device, the first local frame image may include an area in the first frame image and corresponds to a ridge of the alternating-current signal, and the second local frame image may include an area in the second frame image and corresponds to a valley of the alternating-current signal.
In this case, it is possible to increase the amount of shift between the first local frame image and the second local frame image due to the external disturbance magnetic field. Therefore, the charged particle beam device can more accurately calculate the direction and the magnitude of the image displacement vector that is, the direction and the magnitude of the external disturbance magnetic field, using the image displacement vector calculation section.
(4) The charged particle beam device may further include a magnetic sensor that detects an external disturbance magnetic field, and the alternating-current signal may be an output signal from the magnetic sensor.
The charged particle beam device can thus reduce the cyclic distortion of the image that is caused by the external disturbance magnetic field, and acquire an accurate image for which the distortion is reduced.
(5) According to another embodiment of the invention, an image acquisition method is implemented using a charged particle beam device that scans a charged particle beam in synchronization with an alternating-current signal, the image acquisition method including:

an image displacement vector calculation step that calculates an image displacement vector between a first local frame image and a second local frame image, the first local frame image including an area in a first frame image that is obtained by starting scanning at a timing that corresponds to a first phase of the alternating-current signal, and the area in the first frame image corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
a scanning correction signal generation step that generates a scanning correction signal that corrects the scanning of the charged particle beam based on the image displacement vector; and
a scanning signal supply step that supplies a scanning signal that is corrected based on the scanning correction signal to a scanning deflector in synchronization with the alternating-current signal.

According to the image acquisition method, it is possible to scan the charged particle beam while deflecting the charged particle beam so as to cancel the external disturbance magnetic field, by correcting the scanning signal based on the scanning correction signal. This makes it possible to reduce the cyclic distortion of the image that is caused by the external disturbance magnetic field and synchronized with the device power supply cycle, and acquire an accurate image for which the distortion is reduced. The image acquisition method thus makes it possible to implement accurate observation and analysis.

(6) According to another embodiment of the invention, an image acquisition method is implemented in a charged particle beam device that scans a charged particle beam in synchronization with an alternating-current signal, the image acquisition method including:

an image displacement vector calculation step that calculates an image displacement vector between a first local frame image and a second local frame image, the first local frame image including an area in a first frame image that is obtained by starting scanning at a timing that corresponds to a first phase of the alternating-current signal, and the area in the first frame image corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
an address correction signal generation step that generates an address correction signal that corrects an address of a memory pixel included in a frame memory based on the image displacement vector; and
an address selection step that corrects the address of the memory pixel based on the address correction signal, and stores a detection signal detected by a detector in the memory pixel that corresponds to the corrected address.

According to the image acquisition method, it is possible to correct the address of the memory pixel included in the frame memory based on the address correction signal, so that the scanning position of the charged particle beam deflected by the external disturbance magnetic field corresponds to the address of the memory pixel. This makes it possible to reduce the cyclic distortion of the image that is caused by the external disturbance magnetic field and synchronized with the device power supply cycle, and acquire an accurate image for which the distortion is reduced. The image acquisition method thus makes it possible to implement accurate observation and analysis.

(7) In the image acquisition method, the first local frame image may include an area in the first frame image that corresponds to a ridge of the alternating-current signal, and the second local frame image may include an area in the second frame image that corresponds to a valley of the alternating-current signal.

(8) In the image acquisition method, the alternating-current signal may be an output signal from a magnetic sensor that detects an external disturbance magnetic field.

Exemplary embodiments of the invention are described in detail below with reference to the drawings. Note that the following exemplary embodiments do not unduly limit the scope of the invention as stated in the claims. Note also that all of the elements described below should not necessarily be taken as essential elements of the invention.

The charged particle beam devices according to the embodiments of the invention are described below taking a scanning electron microscope (SEM) as an example. Note that the charged particle beam devices according to the embodiments of the invention may also be applied to a charged particle beam device, critical dimension scanning electron microscope for example, other than a scanning electron microscope.

1. First embodiment

1.1. Charged particle beam device

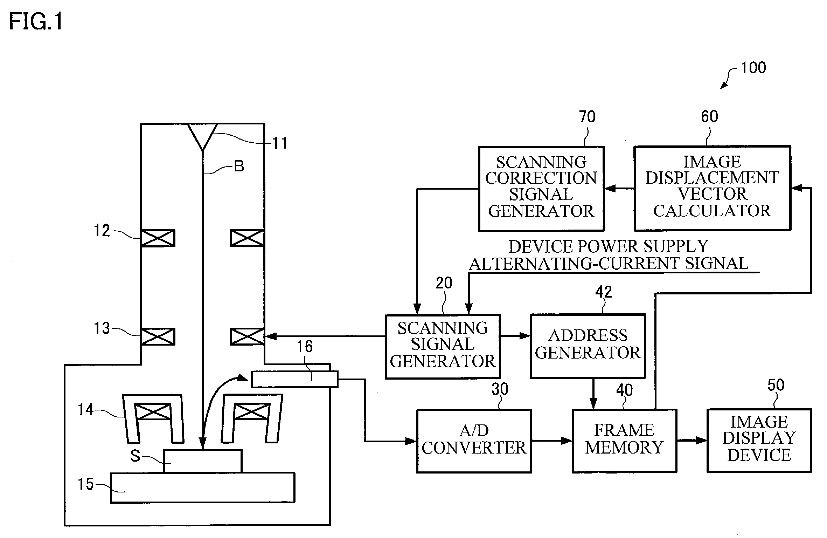

An electron microscope that is an example of a charged particle beam device according to a first embodiment of the invention is described below with reference to the drawings. FIG. 1 is a view schematically illustrating the configuration of an electron microscope 100 according to the first embodiment.

As illustrated in FIG. 1, the electron microscope 100 includes an electron source 11 (i.e., charged particle source), a condenser lens 12, a scanning deflector 13, an objective lens 14, a specimen stage 15, a detector 16, a scanning signal generator 20 (i.e., scanning signal supply section), an A/D converter 30, a frame memory 40, an address generator 42 (i.e., address selection section), an image display device 50, an image displacement vector calculator 60 (i.e., image displacement vector calculation section), and a scanning correction signal generator 70 (i.e., scanning correction signal generation section).

The electron microscope 100 also includes various lenses, an aperture, and the like (not illustrated). The electron microscope 100 may have a configuration in which some of the elements illustrated in FIG. 1 are omitted or changed, or may have a configuration in which an additional element is further provided.

The electron source 11 is a known electron gun, for example. The electron source 11 accelerates electrons released from a cathode using an anode to emit an electron beam B. An arbitrary electron gun may be used as the electron source 11. For example, a tungsten filament thermionic-emission electron gun, a thermal field-emission electron gun, a cold cathode field-emission electron gun, or the like may be used as the electron source 11.

The condenser lens 12 focuses the electron beam B emitted from the electron source 11.

The scanning deflector 13 scans the electron beam B over a specimen S while deflecting the electron beam B. The scanning deflector 13 includes an electromagnetic coil, and deflects the electron beam B using a magnetic field, for example. The scanning deflector 13 can two-dimensionally scan the electron beam B while deflecting the electron beam B. The scanning deflector 13 scans the electron beam B based on an output signal (i.e., a scanning signal to which a scanning correction signal is added (described later)) from the scanning signal generator 20.

The objective lens 14 focuses the electron beam B. The electron microscope 100 scans the electron beam B (electron probe) focused by the condenser lens 12 and the objective lens 14 over the specimen S using the scanning deflector 13.

The specimen stage 15 supports the specimen S, and allows for example vertical and horizontal movement, rotation and tilting in the specimen S.

The detector 16 detects a signal that is secondary electrons or backscattered electrons obtained by applying the focused electron beam B to the specimen S. The detection signal, that is secondary electron or backscattered electron detection signal detected by the detector 16 is converted into a digital signal by the A/D converter 30, and stored in the frame memory 40.

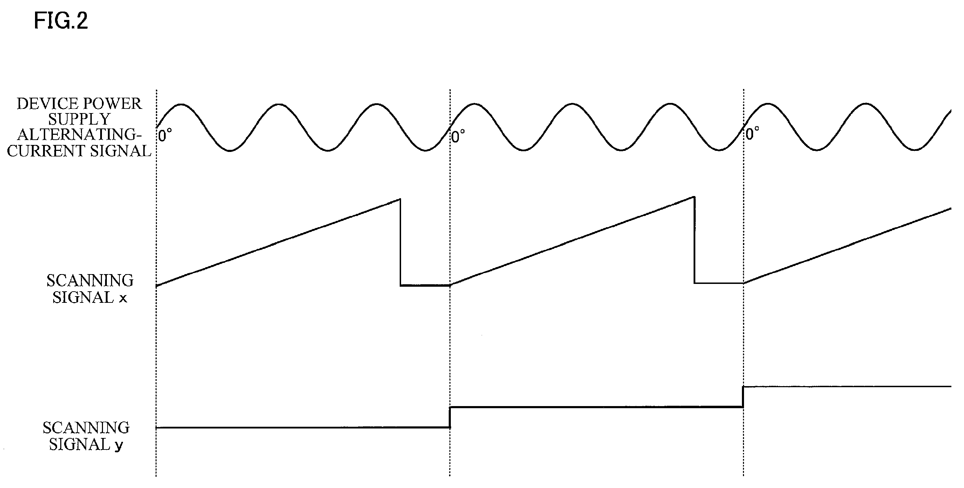

The scanning signal generator 20 generates the scanning signal for scanning the electron beam B. For example, the scanning signal is a signal for raster-scanning the electron beam B (see FIG. 2, for example). Raster scanning refers to a method which scans the electron beam B one-dimensionally to obtain scanning lines and the electron beam B in the direction perpendicular to the scanning lines to obtain a two-dimensional image.

When the scanning correction signal is input to the scanning signal generator 20 from the scanning correction signal generator 70 described later, the scanning signal generator 20 adds the scanning correction signal to the scanning signal to correct the scanning signal. The scanning signal generator 20 outputs the scanning signal to which the scanning correction signal is added to the scanning deflector 13 and the address generator 42.

The electron microscope 100 scans the electron beam B in synchronization with a device power supply alternating-current signal. The device power supply alternating-current signal is supplied to the scanning signal generator 20 from a power supply unit (not illustrated) of the electron microscope 100. The device power supply alternating-current signal has a commercial power supply frequency, and is represented by a sine function, for example. The scanning signal generator 20 outputs the scanning signal to which the scanning correction signal is added in synchronization with the device power supply alternating-current signal. The electron beam B is scanned in synchronization with the device power supply alternating-current signal, and each scanning line (raster scanning line) is started from the same phase of the device power supply alternating-current signal.

The frame memory 40 includes a plurality of memory pixels. For example, the frame memory 40 includes the memory pixels that correspond to one frame. The detection signal detected by the detector 16 is stored in the memory pixel that is included in the frame memory 40 and has an address that corresponds to the scanning signal to which the scanning correction signal is added.

Specifically, when storing the detection signal in the frame memory 40, the address generator 42 generates an address signal that selects the address of the memory pixel in the frame memory 40 corresponding to the scanning signal to which the scanning correction signal is added, and outputs the generated address signal to the frame memory 40. The detection signal is converted into a digital signal by the A/D converter 30, and stored in the memory pixel that is included in the frame memory 40 and has the selected address. The detection signal is thus stored in the memory pixel that is included in the frame memory 40 and has an address that corresponds to the scanning position of the electron beam B.

The image display device 50 reads the image data (the detection signal) stored in each memory pixel included in the frame memory 40, and displays an SEM image of the specimen S.

The image displacement vector calculator 60 calculates an image displacement vector from two local frame images described later. The scanning correction signal generator 70 generates the scanning correction signal from the calculated image displacement vector. The operation of the image displacement vector calculator 60 and the operation of the scanning correction signal generator 70 are described in detail below.

The image displacement vector calculator 60 acquires a first frame image and a second frame image from the frame memory 40. The first frame image is obtained by starting raster scanning at a timing that corresponds to the phase 0° of the device power supply alternating-current signal. The second frame image is obtained by starting raster scanning at a timing that corresponds to the phase 180° of the device power supply alternating-current signal.

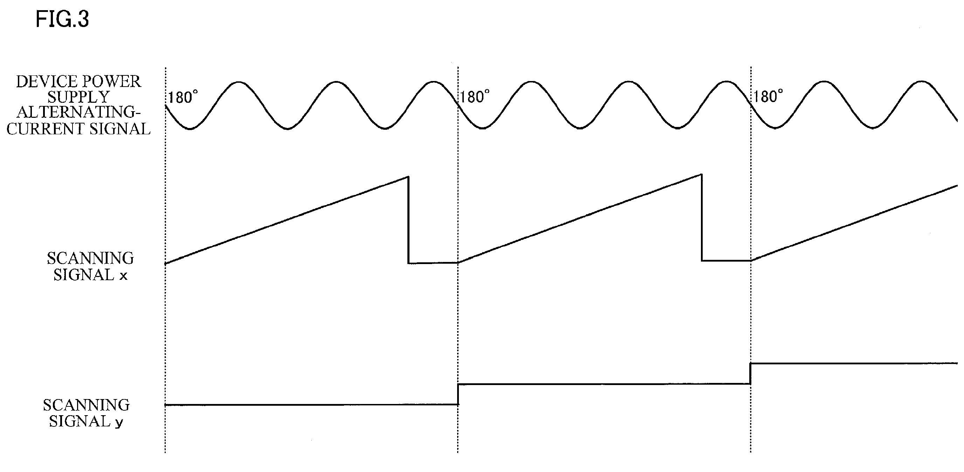

FIG. 2 is a view illustrating an example of the scanning signal when raster scanning is started at a timing that corresponds to the phase 0° of the device power supply alternating-current signal. FIG. 3 is a view illustrating an example of the scanning signal when raster scanning is started at a timing that corresponds to the phase 180° of the device power supply alternating-current signal.

The expression "raster scanning is started at a timing that corresponds to the phase 0° of the device power supply alternating-current signal" means that the scanning of the electron beam B that draws each scanning line is started at a timing that corresponds to the phase 0° of the device power supply alternating-current signal (see FIG. 2). Each scanning line (raster scanning line) can thus be started from the phase 0° of the device power supply alternating-current signal. This also applies to the example of phase 180° illustrated in FIG. 3 and a phase other than 0° and 180°.

As illustrated in FIGS. 2 and 3, the scanning signal includes a scanning signal (x) for scanning the electron beam B in the x-direction (the direction along the scanning line), and a scanning signal (y) for scanning the electron beam B in the y-direction (the direction perpendicular to the scanning line). In the examples illustrated in FIGS. 2 and 3, the scanning signal (x) has a sawtooth-like signal waveform, and the scanning signal (y) has a step-like signal waveform.

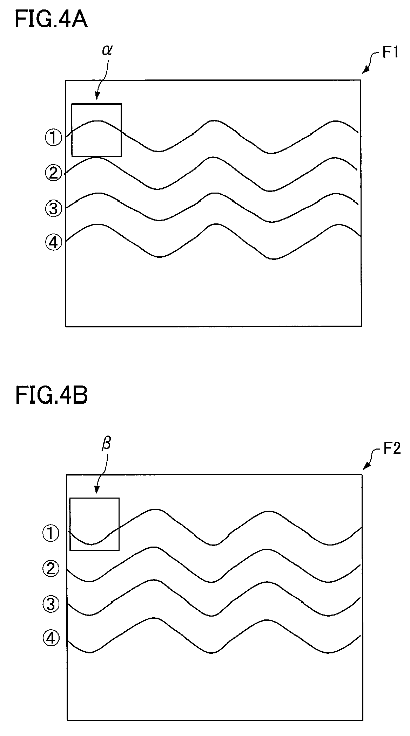

FIG. 4A is a view schematically illustrating a first frame image F1 obtained by starting raster scanning at a timing that corresponds to the phase 0° of the device power supply alternating-current signal. FIG. 4B is a view schematically illustrating a second frame image F2 obtained by starting raster scanning at a timing that corresponds to the phase 180° of the device power supply alternating-current signal. Note that each line within the frame illustrated in FIGS. 4A and 4B represents the scanning line, and each number illustrated in FIGS. 4A and 4B is a number assigned to each scanning line.

The scanning signal generator 20 supplies the scanning signal to the scanning deflector 13 at a timing that corresponds to the phase 0° of the device power supply alternating-current signal to obtain the first frame image F1 illustrated in FIG. 4A. The scanning signal generator 20 supplies the scanning signal to the scanning deflector 13 at a timing that corresponds to the phase 180° of the device power supply alternating-current signal to obtain the second frame image F2 illustrated in FIG. 4B. The first frame image F1 and the second frame image F2 are obtained by scanning the same measurement area of the specimen S with the electron beam B under the same measurement conditions, except that raster scanning is started at a different timing.

The image displacement vector calculator 60 extracts an area that corresponds to the phase 90° of the device power supply alternating-current signal from the acquired first frame image F1 to obtain a first local frame image alpha (see FIG. 4A). The image displacement vector calculator 60 extracts an area that corresponds to the phase 270° of the device power supply alternating-current signal from the acquired second frame image F2 to obtain a second local frame image beta (see FIG. 4B).

Note that the area that corresponds to the phase 90° of the device power supply alternating-current signal refers to an area of the frame image that is obtained by scanning the specimen S with the electron beam B at a timing that corresponds to the phase 90° of the device power supply alternating-current signal. This also applies to an area that corresponds to the phase 180° and an area that corresponds to a phase other than 90° and 180°.

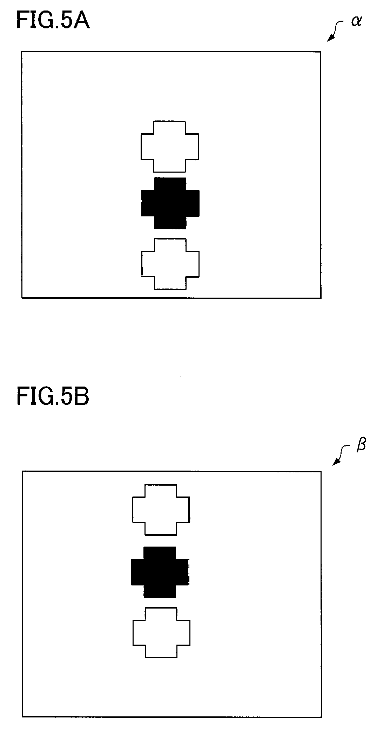

FIG. 5A is a view schematically illustrating the first local frame image alpha, and FIG. 5B is a view schematically illustrating the second local frame image beta.

The first local frame image alpha and the second local frame image beta are images that are formed around an area that corresponds to a phase that is shifted by 90° from the phase when raster scanning is started. The first local frame image alpha and the second local frame image beta are images that respectively represent the corresponding areas (i.e., areas that are identical in position and size within the frame) of the first frame image F1 and the second frame image F2. Therefore, the first local frame image alpha and the second local frame image beta are identical, when the electron beam B is not affected by the external disturbance magnetic field.

The size of the first local frame image alpha and the second local frame image beta (the size of the area extracted from the first frame image F1 and the second frame image F2) may be set appropriately. For example, when the size of the first frame image F1 and the second frame image F2 is 1280x960 pixels, the size of the first local frame image alpha and the second local frame image beta is about 128x128 pixels.

Note that it is desirable that the size of the first local frame image alpha and the second local frame image beta which are formed around the area that corresponds to the phase 90° and the area that corresponds to the phase 270°, respectively be as small as possible as long as it is possible to ensure the accuracy of the cross-correlation calculation process described later, in order to accurately calculate the image displacement vector.

As illustrated in FIG. 4A, the phase 90° of the device power supply alternating-current signal (sine wave) corresponds to the ridge of the device power supply alternating-current signal where the amplitude of an external disturbance magnetic field that is synchronized with the device power supply alternating-current signal becomes a maximum. Therefore, the maximum image shift occurs corresponding to the phase 90° of the device power supply alternating-current signal. In the example illustrated in FIG. 4A, the electron beam B is shifted upward to the maximum extent at a timing that corresponds to the phase 90°, and the pattern of the first local frame image alpha is shifted downward to the maximum extent (see FIG. 5A).

As illustrated in FIG. 4B, the phase 270° of the device power supply alternating-current signal (sine wave) corresponds to the valley of the device power supply alternating-current signal where the amplitude of an external disturbance magnetic field that is synchronized with the device power supply alternating-current signal becomes a maximum in the direction opposite to the direction in which the amplitude of an external disturbance magnetic field becomes a maximum, when the phase of the device power supply alternating-current signal is 90°. In the example illustrated in FIG. 4B, the electron beam B is shifted downward to the maximum extent at a timing that corresponds to the phase 270°, and the pattern of the second local frame image beta is shifted upward to the maximum extent (see FIG. 5B).

Therefore, the angle of the image displacement vector between the first local frame image alpha and the second local frame image beta corresponds to the angle of the external disturbance magnetic field, and the magnitude of the image displacement vector between the first local frame image alpha and the second local frame image beta corresponds to the magnitude of the external disturbance magnetic field. Note that the image displacement vector between the first local frame image alpha and the second local frame image beta is a vector that represents the shift direction and the shift amount between the first local frame image alpha and the second local frame image beta.

The image displacement vector calculator 60 calculates the image displacement vector G between the first local frame image alpha and the second local frame image beta.

For example, the image displacement vector calculator 60 calculates the image displacement vector G by performing a cross-correlation calculation process on the first local frame image alpha and the second local frame image beta. In this case, the cross-correlation calculation process calculates the inverse Fourier transform of the product of the complex conjugate of the two-dimensional Fourier transform of the first local frame image alpha and the second local frame image beta. The coordinates of the maximum value obtained by the two-dimensional cross-correlation calculation process are taken as the image displacement vector.

The scanning correction signal generator 70 generates the scanning correction signal for correcting the scanning of the electron beam B based on the image displacement vector calculated by the image displacement vector calculator 60.

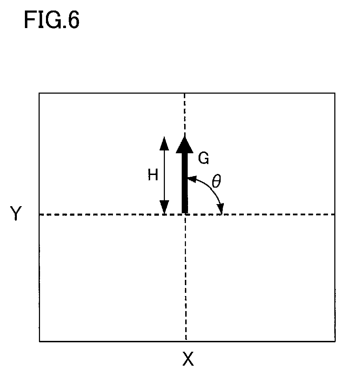

FIG. 6 is a view illustrating the scanning correction signal. FIG. 6 illustrates the image displacement vector G in the scanning correction signal coordinate system (X, Y).

The scanning correction signal generator 70 generates the scanning correction signal that produces an inverse vector from the angle theta and the magnitude H of the external disturbance magnetic field. The coordinate system of the scanning correction signal in the X-direction and the Y-direction is a coordinate system in which the origin is the scanning position (x, y) at a certain point represented by the uncorrected scanning signal (see 4A and 4B). The intensity $G_x$ of the external disturbance magnetic field in the X-direction is calculated by the following expression (1).

$$G_x = -kH \cos \theta \cdots (1)$$

Note that k is a device-specific constant. k may be set arbitrarily.

The intensity $G_y$ of the external disturbance magnetic field in the Y-direction is calculated by the following expression (2).

$$G_y = -kH \sin \theta \cdots (2)$$

The scanning correction signal is generated using the following sine function expressions (3) and (4) (X-direction and Y-direction).

$$X = G_x \sin\left(\frac{2\pi x}{c}\right) \cdots (3)$$

$$Y = G_y \sin\left(\frac{2\pi x}{c}\right) \cdots (4)$$

Note that C is a value determined from the cycle of the device power supply alternating-current signal that is known in advance.

The scanning signal generator 20 adds the scanning correction signal generated by the scanning correction signal generator 70 to the scanning signal. Note that the intensity $G_x$ in the X-direction is 0 in the example illustrated in FIG. 6.

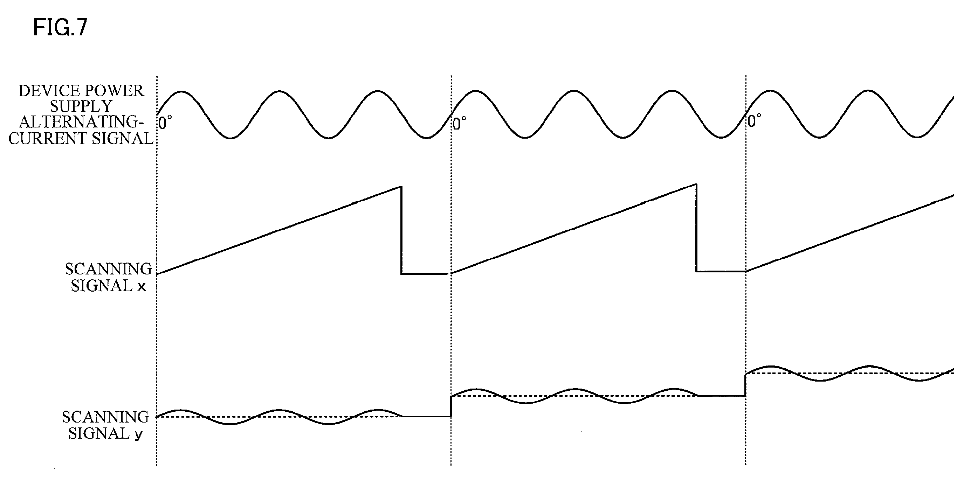

FIG. 7 is a view illustrating an example of the results obtained by adding the scanning correction signal to the scanning signal, when the intensity $G_y$ of the external disturbance magnetic field in the Y-direction is other than 0 (intensity $G_x$=0 (i.e., the example illustrated in FIG. 6)). In FIG. 7, the scanning signal is indicated by the dotted line, and the results obtained by adding the scanning correction signal to the scanning signal are indicated by the solid line.

As illustrated in FIG. 7, the scanning correction signal is added to the scanning signal to correct the scanning signal. In the example illustrated in FIG. 7, the scanning correction signal is added to only the scanning signal (y) since the intensity $G_x$ of the external disturbance magnetic field in the X-direction is 0. It is possible to reduce the shift of the image in the y-direction (vertical direction) that is synchronized with the device power supply alternating-current signal (see FIGS. 5A and 5B) by adding the scanning correction signal to the scanning signal (y).

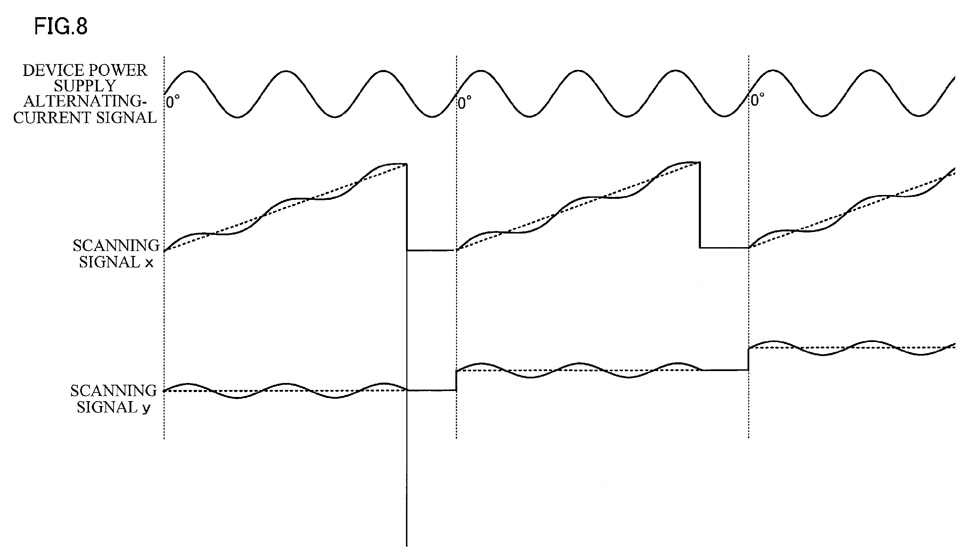

FIG. 8 is a view illustrating an example of the results obtained by adding the scanning correction signal to the scanning signal when the intensity $G_x$ of the external disturbance magnetic field in the X-direction and the intensity $G_y$ of the external disturbance magnetic field in the Y-direction are not 0. In FIG. 8, the scanning signal is indicated by the dotted line, and the results obtained by adding the scanning correction signal to the scanning signal are indicated by the solid line.

In the example illustrated in FIG. 8, the scanning correction signal is respectively superimposed on the scanning signal (x) and the scanning signal (y). It is possible to reduce the expansion and contraction of the image in the x-direction that is synchronized with the device power supply alternating-current signal by superimposing the scanning correction signal on the scanning signal (x).

The scanning signal generator 20 supplies the scanning signal to which the scanning correction signal is added to the scanning deflector 13 at a timing that corresponds to the phase 0° of the device power supply alternating-current signal, for example. This makes it possible to scan the electron beam B while deflecting the electron beam B so as to cancel the external disturbance magnetic field, and linearly scan the electron beam B.

1.2. Image acquisition method

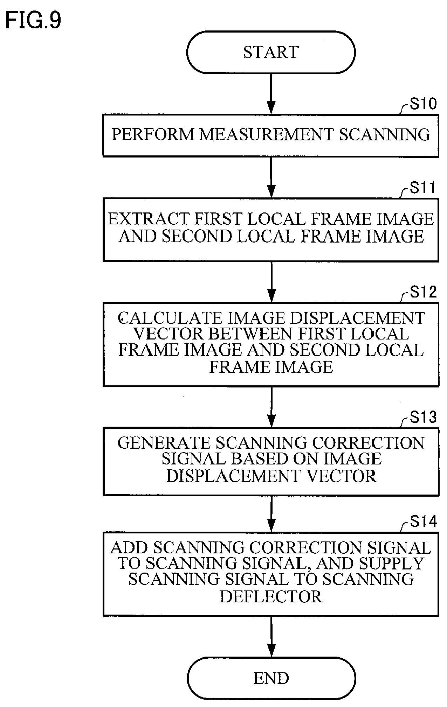

An image acquisition method that is implemented in the electron microscope 100 which is an example of the charged particle beam device is described below with reference to FIG. 9. FIG. 9 is a flowchart illustrating an example of the image acquisition method that is implemented in the electron microscope 100 according to the first embodiment.

The electron microscope 100 performs measurement scanning for acquiring the frame image F1 and the frame image F2 (step S10).

The electron microscope 100 starts measurement scanning at a timing at which the scanning speed of the electron beam B is changed, for example. Measurement scanning may be carried out after the user has pressed a photographing start switch (not illustrated in the drawings), but before the photographing operation is performed, for example.

The scanning signal generator 20 supplies the scanning signal to the scanning deflector 13 at a timing that corresponds to the phase 0° of the device power supply alternating-current signal to implement raster scanning corresponding to one frame, and then supplies the scanning signal to the scanning deflector 13 at a timing that corresponds to the phase 180° of the device power supply alternating-current signal to implement raster scanning corresponding to one frame.

The frame image F1 is recorded in the frame memory 40 by implementing raster scanning at a timing that corresponds to the phase 0° of the device power supply alternating-current signal. The frame image F2 is recorded in the frame memory 40 by implementing raster scanning at a timing that corresponds to the phase 180° of the device power supply alternating-current signal.

The image displacement vector calculator 60 extracts the first local frame image alpha from the frame image F1, and extracts the second local frame image beta from the frame image F2 (step S11).

The image displacement vector calculator 60 then calculates the image displacement vector between the first local frame image alpha and the second local frame image beta (step S12).

The scanning correction signal generator 70 generates the scanning correction signal based on the image displacement vector generated by the image displacement vector calculator 60 (step S13).

The scanning signal generator 20 adds the scanning correction signal to the scanning signal, and supplies the scanning signal to which the scanning correction signal is added to the scanning deflector 13 (step S14).

The scanning signal generator 20 supplies the scanning signal to which the scanning correction signal is added to the scanning deflector 13 at a timing that corresponds to the phase 0° of the device power supply alternating-current signal. The detection signal detected by the detector 16 is stored in the memory pixel that is included in the frame memory 40 and has an address that corresponds to the scanning position of the electron beam B in synchronization with the scanning signal to which the scanning correction signal is added.

The image display device 50 reads the image data (the detection signal) stored in each memory pixel included in the frame memory 40, and displays an SEM image of the specimen S.

An SEM image can be acquired by performing the above steps.

The electron microscope 100 has the following features, for example.

The electron microscope 100 is configured so that the image displacement vector calculator 60 calculates the image displacement vector between the first local frame image alpha and the second local frame image beta. The first local frame image alpha includes an area in the frame image F1 that is obtained by starting scanning at a timing that corresponds to the phase 0° of the device power supply alternating-current signal, and the area in the frame image F1 corresponds to the phase 90°. The second local frame image beta includes an area in the frame image F2 that is obtained by starting scanning at a timing that corresponds to the phase 180° of the device power supply alternating-current signal, and the area in the frame image F2 corresponds to the phase 270°. The scanning correction signal generator 70 generates the scanning correction signal based on the image displacement vector. Therefore, the electron microscope 100 can correct the scanning signal based on the scanning correction signal, and scan the electron beam B while deflecting the electron beam B so as to cancel the external disturbance magnetic field. This makes it possible to reduce the cyclic distortion of the image that is caused by the external disturbance magnetic field and synchronized with the device power supply cycle, and acquire an accurate image for which the distortion is reduced. The electron microscope 100 can thus implement accurate observation and analysis.

The electron microscope 100 is configured so that the first local frame image alpha includes an image that corresponds to the ridge of the device power supply alternating-current signal, and the second local frame image beta includes an image that corresponds to the valley of the device power supply alternating-current signal. This makes it possible to increase (maximize) the amount of shift between the first local frame image alpha and the second local frame image beta due to the external disturbance magnetic field. Therefore, the electron microscope 100 can more accurately calculate the direction and the magnitude of the image displacement vector, that is, the direction and the magnitude of the external disturbance magnetic field) using the image displacement vector calculator 60.

The image acquisition method according to the first embodiment includes an image displacement vector calculation step (step S12) that calculates the image displacement vector between the first local frame image alpha and the second local frame image beta. The first local frame image alpha includes an area in the frame image F1 that is obtained by starting scanning at a timing that corresponds to the phase 0° of the device power supply alternating-current signal. The area in the frame image F1 corresponds to the phase 90°. The second local frame image beta includes an area in the frame image F2 that is obtained by starting scanning at a timing that corresponds to the phase 180° of the device power supply alternating-current signal, and the area in the frame image F2 corresponds to the phase 270° A scanning correction signal generation step (step S13) that generates the scanning correction signal based on the image displacement vector. Therefore, it is possible to correct the scanning signal based on the scanning correction signal, and scan the electron beam B while deflecting the electron beam B so as to cancel the external disturbance magnetic field. This makes it possible to reduce the cyclic distortion of the image that is caused by the external disturbance magnetic field and synchronized with the device power supply cycle, and acquire an accurate image for which the distortion is reduced. The image acquisition method according to the first embodiment thus makes it possible to implement accurate observation and analysis.

2. Second embodiment

2.1. Charged particle beam device

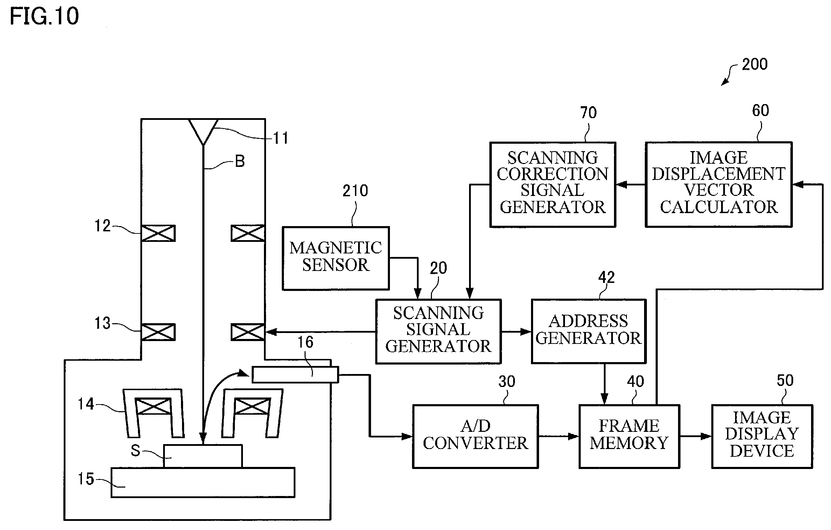

An electron microscope that is an example of a charged particle beam device according to a second embodiment of the invention is described below with reference to the drawings. FIG. 10 is a view schematically illustrating the configuration of an electron microscope 200 according to the second embodiment. Note that the members of the electron microscope 200 according to the second embodiment that are identical in function to those of the electron microscope 100 according to the first embodiment are indicated by the same reference signs (symbols), and the description thereof is omitted.

The electron microscope 100 according to the first embodiment is configured so that the scanning signal generator 20 uses the device power supply alternating-current signal as a signal with which raster scanning is synchronized (see FIG. 1).

The electron microscope 200 according to the second embodiment includes a magnetic sensor 210 (see FIG. 10), and the scanning signal generator 20 uses an output signal from the magnetic sensor 210 as a signal with which raster scanning is synchronized.

The magnetic sensor 210 can detect an external disturbance magnetic field. The magnetic sensor 210 is provided near the optical column of the electron microscope 200, for example.

2.2. Image acquisition method

An image acquisition method that is implemented using the electron microscope 200 according to the second embodiment is the same as the image acquisition method that is implemented using the electron microscope 100 according to the first embodiment (see FIG. 9), except that the output signal from the magnetic sensor 210 is used instead of the device power supply alternating-current signal, and the description thereof is omitted.

The electron microscope 200 according to the second embodiment and the image acquisition method that is implemented in the electron microscope 200 according to the second embodiment make it possible to reduce the cyclic distortion of the image that is caused by the external disturbance magnetic field, and acquire an accurate image for which the distortion is reduced in the same manner as the electron microscope 100 according to the first embodiment and the image acquisition method that is implemented in the electron microscope 100 according to the first embodiment.

3. Third embodiment

3.1. Charged particle beam device

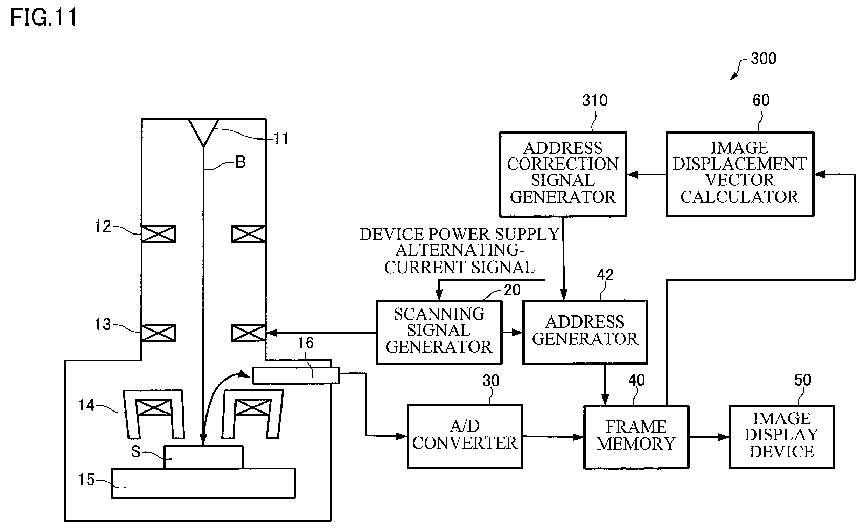

An electron microscope that is an example of a charged particle beam device according to a third embodiment of the invention is described below with reference to the drawings. FIG. 11 is a view schematically illustrating the configuration of an electron microscope 300 according to the third embodiment. Note that the members of the electron microscope 300 according to the third embodiment that are identical in function to those of the electron microscope 100 according to the first embodiment are indicated by the same reference signs (symbols), and description thereof is omitted.

The electron microscope 100 according to the first embodiment is configured so that the scanning signal generator 20 corrects the scanning signal by adding the scanning correction signal generated by the scanning correction signal generator 70 to the scanning signal to acquire an SEM image for which the distortion is reduced (see FIG. 1).

The electron microscope 300 according to the third embodiment includes an address correction signal generator 310 (that is , an example of the address correction signal generation section) as shown in FIG. 11, and the address generator 42 corrects the address of the memory pixel included in the frame memory 40 based on the address correction signal generated by the address correction signal generator 310, and stores the detection signal detected by the detector 16 in the memory pixel that has the corrected address to acquire an SEM image for which the distortion is reduced.

The address correction signal generator 310 generates the address correction signal based on the image displacement vector calculated by the image displacement vector calculator 60 in the same manner as the scanning correction signal generator 70 (see FIG. 1). The address correction signal generator 310 generates the address correction signal that corrects the address of each memory pixel so that the scanning position of the electron beam B deflected by the external disturbance magnetic field corresponds to the address of the memory pixel from the angle theta and the magnitude H of the external disturbance magnetic field.

The electron microscope 300 is configured so that the scanning signal generator 20 outputs the scanning signal (the scanning signal (x) that has a sawtooth-like signal waveform, and the scanning signal (y) that has a step-like signal waveform) to the scanning deflector 13 and the address generator 42 in synchronization with the device power supply alternating-current signal.

The address generator 42 corrects the address of the memory pixel included in the frame memory 40 based on the address correction signal, and stores the detection signal detected by the detector 16 at the corrected address.

For example, the address generator 42 corrects the address that corresponds to the scanning signal from the scanning signal generator 20 based on the address correction signal to generate information about the new address. The address generator 42 outputs the address signal that includes the information about the new address to the frame memory 40. The detection signal is converted into a digital signal by the A/D converter 30, and stored in the memory pixel that has the address selected by the address signal. The selected address has been corrected so that the scanning position of the electron beam B corresponds to the address of the memory pixel. The detection signal is thus stored in the memory pixel that is included in the frame memory 40 and has the address that corresponds to the scanning position of the electron beam B.

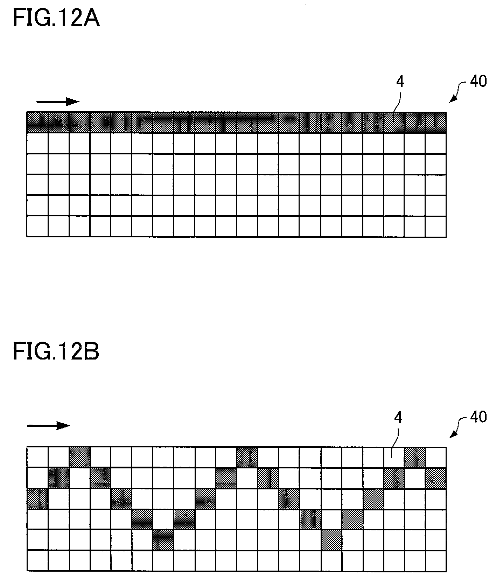

FIG. 12A is a view illustrating the state of the frame memory 40 before the address is corrected, and FIG. 12B is a view illustrating the state of the frame memory 40 after the address is corrected. In FIGS. 12A and 12B, memory pixels 4 in which the detection signal is stored are indicated by the dark color.

Since the raster scanning lines normally extend linearly, the detection signal is sequentially stored in the memory pixels 4 that are included in the frame memory 40 and arranged linearly corresponding to the scanning signal. However, when the electron beam B is deflected by the external disturbance magnetic field, and the raster scanning lines are distorted cyclically, the resulting image is distorted, if the detection signal is sequentially stored in the memory pixels 4 that are arranged linearly corresponding to the scanning signal (see FIG. 12A).

Therefore, the address generator 42 corrects the address of each memory pixel based on the address correction signal so that the scanning position of the electron beam B deflected by the external disturbance magnetic field corresponds to the address of the memory pixel (see FIG. 12B). This makes it possible to reduce the cyclic distortion of the image caused by the external disturbance magnetic field.

3.2. Image acquisition method

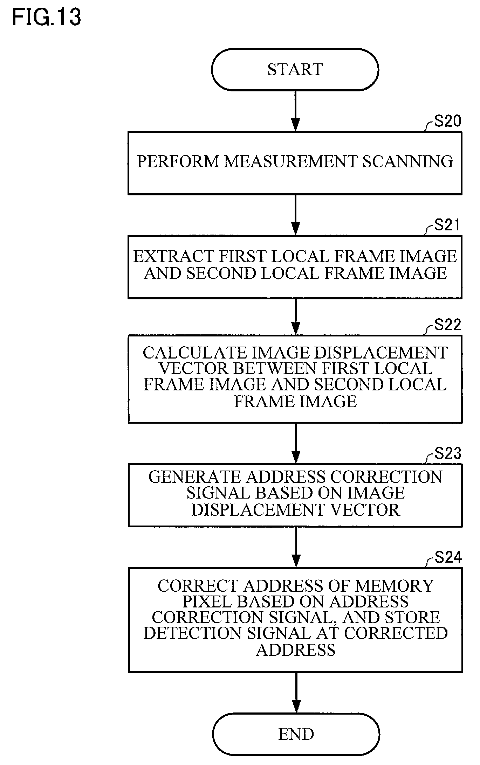

An image acquisition method that is implemented in the electron microscope 300 as an example of a charged particle beam device is described below with reference to FIG. 13. FIG. 13 is a flowchart illustrating an example of the image acquisition method that is implemented in the electron microscope 300 according to the third embodiment.

The electron microscope 300 performs measurement scanning for acquiring the frame image F1 and the frame image F2 (step S20).

The image displacement vector calculator 60 extracts the first local frame image alpha from the frame image F1, and extracts the second local frame image beta from the frame image F2 (step S21).

The image displacement vector calculator 60 then calculates the image displacement vector between the first local frame image alpha and the second local frame image beta (step S22).

The steps S20 to S22 are respectively the same as the steps S10 to S12 illustrated in FIG. 9, and description thereof is omitted.

The address correction signal generator 310 generates the address correction signal based on the image displacement vector generated by the image displacement vector calculator 60 (step S23).

The address generator 42 corrects the address of the memory pixel based on the address correction signal, and stores the detection signal at the corrected address (step S24).

Specifically, the scanning signal generator 20 outputs the scanning signal to the scanning deflector 13 and the address generator 42 in synchronization with the device power supply alternating-current signal. The address generator 42 corrects the address of the memory pixel that corresponds to the input scanning signal based on the address correction signal, and outputs the address signal to the frame memory 40. The detection signal is stored in the memory pixel that has the address selected by the address signal. The detection signal is thus stored in the memory pixel that is included in the frame memory 40 and has the address that corresponds to the scanning position of the electron beam B.

The image display device 50 reads the image data (the detection signal) stored in each memory pixel included in the frame memory 40, and displays an SEM image of the specimen S.

An SEM image can be acquired by performing the above steps.

The electron microscope 300 according to the third embodiment is configured so that the image displacement vector calculator 60 calculates the image displacement vector between the first local frame image alpha and the second local frame image beta, the first local frame image alpha including an area in the frame image F1 that is obtained by starting scanning at a timing that corresponds to the phase 0° of the device power supply alternating-current signal, and the area in the frame image F1 corresponds to the phase 90°; the second local frame image beta including an area in the frame image F2 that is obtained by starting scanning at a timing that corresponds to the phase 180° of the device power supply alternating-current signal, and the area in the frame image F2 corresponds to the phase 270°, and the address correction signal generator 310 generates the address correction signal based on the image displacement vector. Therefore, the electron microscope 300 can correct the address of the memory pixel included in the frame memory 40 based on the address correction signal so that the scanning position of the electron beam B deflected by the external disturbance magnetic field corresponds to the address of the memory pixel. This makes it possible to reduce the cyclic distortion of the image that is caused by the external disturbance magnetic field and synchronized with the device power supply cycle, and acquire an accurate image for which the distortion is reduced. The electron microscope 300 can thus implement accurate observation and analysis.

The image acquisition method according to the third embodiment includes an image displacement vector calculation step (step S22) that calculates the image displacement vector between the first local frame image alpha and the second local frame image beta, the first local frame image alpha including an area in the frame image F1 that is obtained by starting scanning at a timing that corresponds to the phase 0° of the device power supply alternating-current signal, and the area in the frame image F1 corresponds to the phase 90°; the second local frame image beta including an area in the frame image F2 that is obtained by starting scanning at a timing that corresponds to the phase 180° of the device power supply alternating-current signal, and the area in the frame image F2 corresponds to the phase 270°, and an address correction signal generation step (step S23) that generates the address correction signal based on the image displacement vector. This makes it possible to reduce the cyclic distortion of the image that is caused by the external disturbance magnetic field and synchronized with the device power supply cycle, and acquire an accurate image for which the distortion is reduced. The image acquisition method according to the third embodiment thus makes it possible to implement accurate observation and analysis.

## 4. Modifications

The invention is not limited to the above embodiments. Various modifications and variations may be made without departing from the scope of the invention.

(1) First modification

A first modification is described below.

The above embodiments have been described taking an example in which the image displacement vector calculator 60 extracts an area that corresponds to the phase 90° of the device power supply alternating-current signal from the frame image F1 to obtain the first local frame image alpha.

According to the first modification, the area that is extracted by the image displacement vector calculator 60 as the first local frame image alpha is not limited to an area that corresponds to the phase 90°, but may be an area that corresponds to an arbitrary phase other than the phase at which the intensity of the device power supply alternating-current signal becomes 0. For example, when the device power supply alternating-current signal is a sine wave, the area that is extracted by the image displacement vector calculator 60 as the first local frame image alpha may be an area that corresponds to an arbitrary phase other than the phase 0° and the phase 180°.

Likewise, the area that is extracted by the image displacement vector calculator 60 as the second local frame image beta is not limited to an area that corresponds to the phase 270°, but may be an area that corresponds to an arbitrary phase other than the phase at which the intensity of the device power supply alternating-current signal becomes 0.

It is desirable that the first local frame image alpha and the second local frame image beta be images that represent an area around a phase that is shifted by the same phase from the phase that corresponds to the timing at which raster scanning is started. In this case, the first local frame image alpha and the second local frame image beta are identical, when the electron beam B is not affected by the external disturbance magnetic field. Therefore, it is possible to more accurately calculate the direction and the magnitude of the external disturbance magnetic field from the image displacement vector between the first local frame image alpha and the second local frame image beta.

The electron microscope according to the first modification can reduce the cyclic distortion of the image that is caused by the external disturbance magnetic field and synchronized with the device power supply cycle, and acquire an accurate image for which the distortion is reduced in the same manner as the electron microscope 100 according to the first embodiment, the electron microscope 200 according to the second embodiment, and the electron microscope 300 according to the third embodiment.

(2) Second modification

A second modification is described below.
The above embodiments have been described taking an example in which the frame image F1 is an image obtained by starting raster scanning at a timing that corresponds to the phase 0° of the device power supply alternating-current signal (or the alternating-current signal from the magnetic sensor 210), and the frame image F2 is an image obtained by starting raster scanning at a timing that corresponds to the phase 180° of the device power supply alternating-current signal.
According to the second modification, the phase that corresponds to the timing at which raster scanning is started may be an arbitrary phase as long as the frame image F1 and the frame image F2 are images obtained by starting raster scanning at a timing that corresponds to a different phase of the device power supply alternating-current signal.
The electron microscope according to the second modification can reduce the cyclic distortion of the image that is caused by the external disturbance magnetic field and synchronized with the device power supply cycle, and acquire an accurate image for which the distortion is reduced in the same manner as the electron microscope 100 according to the first embodiment, the electron microscope 200 according to the second embodiment, and the electron microscope 300 according to the third embodiment.
Note that the above embodiments and the modifications thereof are merely examples, and the invention is not limited to the above embodiments and the modifications thereof. For example, the above embodiments and the modifications thereof may be appropriately combined.
The invention includes various other configurations substantially the same as the configurations described in connection with the above embodiments (e.g., a configuration having the same function, method, and results, or a configuration having the same objective and effects). The invention also includes a configuration in which an unsubstantial element described in connection with the above embodiments is replaced by another element. The invention also includes a configuration having the same effects as those of the configurations described in connection with the above embodiments, or a configuration capable of achieving the same objective as that of the configurations described in connection with the above embodiments. The invention further includes a configuration in which a known technique is added to the configurations described in connection with the above embodiments.
Although only some embodiments of the invention have been described in detail above, those skilled in the art would readily appreciate that many modifications are possible in the embodiments without materially departing from the novel teachings and advantages of the invention. Accordingly, all such modifications are intended to be included within the scope of the invention, as defined by the claims.

**Claims**

1. A charged particle beam device that scans a charged particle beam in synchronization with an alternating-current signal, the charged particle beam device comprising:

   an image displacement vector calculation section that calculates an image displacement vector between a first local frame image and a second local frame image, the first local frame image including an area in a first frame image that is obtained by starting scanning at a timing that corresponds to a first phase of the alternating-current signal, and the area in the first frame image corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
   a scanning deflector that scans the charged particle beam while deflecting the charged particle beam;
   a scanning correction signal generation section that generates a scanning correction signal that corrects the scanning of the charged particle beam based on the image displacement vector; and
   a scanning signal supply section that supplies a scanning signal that is corrected based on the scanning correction signal to the scanning deflector in synchronization with the alternating-current signal.

2. A charged particle beam device that scans a charged particle beam in synchronization with an alternating-current signal, the charged particle beam device comprising:

   an image displacement vector calculation section that calculates an image displacement vector between a first local frame image and a second local frame image, the first local frame image including an area in a first frame image that is obtained by starting scanning at a timing that corresponds to a first phase of the alternating-current signal, and the area corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
a frame memory that includes a plurality of memory pixels;
an address correction signal generation section that generates an address correction signal that corrects an address of a memory pixel among the plurality of memory pixels based on the image displacement vector; and
an address selection section that corrects the address of the memory pixel based on the address correction signal, and stores a detection signal detected by a detector in the memory pixel that corresponds to the corrected address.

3. The charged particle beam device as defined in claim 1 or 2,
wherein the first local frame image includes an area in the first frame image that corresponds to a ridge of the alternating-current signal, and
the second local frame image includes an area in the second frame image that corresponds to a valley of the alternating-current signal.

4. The charged particle beam device as defined in any one of claims 1 to 3, further comprising:

a magnetic sensor that detects an external disturbance magnetic field,
wherein the alternating-current signal is an output signal from the magnetic sensor.

5. An image acquisition method that is implemented in a charged particle beam device that scans a charged particle beam in synchronization with an alternating-current signal, the image acquisition method comprising:

an image displacement vector calculation step that calculates an image displacement vector between a first local frame image and a second local frame image, the first local frame image including an area in a first frame image that is obtained by starting scanning at a timing that corresponds to a first phase of the alternating-current signal, and the area in the first frame image corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
a scanning correction signal generation step that generates a scanning correction signal that corrects the scanning of the charged particle beam based on the image displacement vector; and
a scanning signal supply step that supplies a scanning signal that is corrected based on the scanning correction signal to a scanning deflector in synchronization with the alternating-current signal.

6. An image acquisition method that is implemented in a charged particle beam device that scans a charged particle beam in synchronization with an alternating-current signal, the image acquisition method comprising:

an image displacement vector calculation step that calculates an image displacement vector between a first local frame image and a second local frame image, the first local frame image including an area in a first frame image that is obtained by starting scanning at a timing that corresponds to a first phase of the alternating-current signal, and the area in the first frame image corresponds to a phase that undergoes a given phase shift from the first phase; the second local frame image including an area in a second frame image that is obtained by starting scanning at a timing that corresponds to a second phase of the alternating-current signal that differs from the first phase, and the area in the second frame image corresponds to a phase that undergoes the given phase shift from the second phase;
an address correction signal generation step that generates an address correction signal that corrects an address of a memory pixel included in a frame memory based on the image displacement vector; and
an address selection step that corrects the address of the memory pixel based on the address correction signal, and stores a detection signal detected by a detector in the memory pixel that corresponds to the corrected address.

7. The image acquisition method as defined in claim 5 or 6,
wherein the first local frame image includes an area in the first frame image that corresponds to a ridge of the alternating-current signal, and
the second local frame image includes an area in the second frame image that corresponds to a valley of the alternating-current signal.

8. The image acquisition method as defined in any one of claims 5 to 7, wherein the alternating-current signal is an output signal from a magnetic sensor that detects an external disturbance magnetic field.

FIG.1

SCANNING CORRECTION SIGNAL GENERATOR — 70

IMAGE DISPLACEMENT VECTOR CALCULATOR — 60

100

DEVICE POWER SUPPLY
ALTERNATING-CURRENT SIGNAL

SCANNING SIGNAL GENERATOR — 20

ADDRESS GENERATOR — 42

A/D CONVERTER — 30

FRAME MEMORY — 40

IMAGE DISPLAY DEVICE — 50

FIG.2

DEVICE POWER
SUPPLY
ALTERNATING-
CURRENT SIGNAL

SCANNING
SIGNAL x

SCANNING
SIGNAL y

FIG.3

DEVICE POWER SUPPLY ALTERNATING-CURRENT SIGNAL

180°   180°   180°

SCANNING SIGNAL x

SCANNING SIGNAL y

EP 3 029 710 A1

FIG.4A

FIG.4B

FIG.5A

FIG.5B

FIG.6

FIG.7

DEVICE POWER
SUPPLY
ALTERNATING-
CURRENT SIGNAL

0°          0°          0°

SCANNING
SIGNAL x

SCANNING
SIGNAL y

EP 3 029 710 A1

FIG.8

DEVICE POWER
SUPPLY
ALTERNATING-
CURRENT SIGNAL

0°   0°   0°

SCANNING
SIGNAL x

SCANNING
SIGNAL y

EP 3 029 710 A1

## FIG.9

```
                    ┌─────────────────┐
                    │      START      │
                    └─────────────────┘
                             │
                             ▼                    ┌S10
        ┌────────────────────────────────────────┐
        │      PERFORM MEASUREMENT SCANNING        │
        └────────────────────────────────────────┘
                             │
                             ▼                    ┌S11
        ┌────────────────────────────────────────┐
        │    EXTRACT FIRST LOCAL FRAME IMAGE       │
        │    AND SECOND LOCAL FRAME IMAGE          │
        └────────────────────────────────────────┘
                             │
                             ▼                    ┌S12
        ┌────────────────────────────────────────┐
        │    CALCULATE IMAGE DISPLACEMENT          │
        │    VECTOR BETWEEN FIRST LOCAL            │
        │    FRAME IMAGE AND SECOND LOCAL          │
        │    FRAME IMAGE                           │
        └────────────────────────────────────────┘
                             │
                             ▼                    ┌S13
        ┌────────────────────────────────────────┐
        │    GENERATE SCANNING CORRECTION          │
        │    SIGNAL BASED ON IMAGE                 │
        │    DISPLACEMENT VECTOR                   │
        └────────────────────────────────────────┘
                             │
                             ▼                    ┌S14
        ┌────────────────────────────────────────┐
        │    ADD SCANNING CORRECTION SIGNAL        │
        │    TO SCANNING SIGNAL, AND SUPPLY        │
        │    SCANNING SIGNAL TO SCANNING           │
        │    DEFLECTOR                             │
        └────────────────────────────────────────┘
                             │
                             ▼
                    ┌─────────────────┐
                    │       END       │
                    └─────────────────┘
```

FIG.10

IMAGE
DISPLAY
DEVICE

50

FRAME
MEMORY

40

A/D
CONVERTER

30

ADDRESS
GENERATOR

42

SCANNING
SIGNAL
GENERATOR

20

MAGNETIC
SENSOR

210

IMAGE
DISPLACEMENT
VECTOR
CALCULATOR

60

SCANNING
CORRECTION
SIGNAL
GENERATOR

70

200

15

S

14

16

13

12

11

B

26

FIG.11

FIG.12A

4    40

FIG.12B

4    40

# FIG.13

START

⌐S20

PERFORM MEASUREMENT SCANNING

⌐S21

EXTRACT FIRST LOCAL FRAME IMAGE
AND SECOND LOCAL FRAME IMAGE

⌐S22

CALCULATE IMAGE DISPLACEMENT
VECTOR BETWEEN FIRST LOCAL
FRAME IMAGE AND SECOND LOCAL
FRAME IMAGE

⌐S23

GENERATE ADDRESS CORRECTION
SIGNAL BASED ON IMAGE
DISPLACEMENT VECTOR

⌐S24

CORRECT ADDRESS OF MEMORY
PIXEL BASED ON ADDRESS
CORRECTION SIGNAL, AND STORE
DETECTION SIGNAL AT CORRECTED
ADDRESS

END

FIG.14

FIG.15

DEVICE POWER SUPPLY ALTERNATING-CURRENT SIGNAL

101

- 111
- B
- 112
- 113
- 116
- 114
- S
- 115

120 SCANNING SIGNAL GENERATOR

142 ADDRESS GENERATOR

130 A/D CONVERTER

140 FRAME MEMORY

150 IMAGE DISPLAY DEVICE

EP 3 029 710 A1

FIG.16

**EUROPEAN SEARCH REPORT**

Application Number

EP 15 19 7337

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2007 324044 A (HITACHI HIGH TECH CORP) 13 December 2007 (2007-12-13) * abstract; figures 1, 4, 5 * * paragraphs [0007] - [0009], [0013] - [0017], [0019] - [0021], [0024] - [0038], [0045] * | 1,3-5,7,8 | INV. H01J37/147 H01J37/28 |
| A | US 4 791 294 A (FURUYA TOSHIHIRO [JP]) 13 December 1988 (1988-12-13) * abstract; figures * * column 2, lines 17-55 * | 1,4,5,8 | |
| X | US 4 907 287 A (HOMMA KOICHI [JP] ET AL) 6 March 1990 (1990-03-06) * column 22, line 11 - column 24, line 42; figures 1, 21, 22 * | 2,4,6,8 | |

TECHNICAL FIELDS SEARCHED (IPC)

H01J

The present search report has been drawn up for all claims

| Place of search | Date of completion of the search | Examiner |
|---|---|---|
| Munich | 30 March 2016 | Schmidt-Kärst, S |

**EP 3 029 710 A1**

## ANNEX TO THE EUROPEAN SEARCH REPORT
## ON EUROPEAN PATENT APPLICATION NO.

EP 15 19 7337

This annex lists the patent family members relating to the patent documents cited in the above-mentioned European search report.
The members are as contained in the European Patent Office EDP file on
The European Patent Office is in no way liable for these particulars which are merely given for the purpose of information.

30-03-2016

| Patent document cited in search report | | Publication date | Patent family member(s) | | Publication date |
|---|---|---|---|---|---|
| JP 2007324044 | A | 13-12-2007 | JP | 4917839 B2 | 18-04-2012 |
| | | | JP | 2007324044 A | 13-12-2007 |
| US 4791294 | A | 13-12-1988 | JP | S6394547 A | 25-04-1988 |
| | | | JP | H06105601 B2 | 21-12-1994 |
| | | | US | 4791294 A | 13-12-1988 |
| US 4907287 | A | 06-03-1990 | NONE | | |

EPO FORM P0459

For more details about this annex : see Official Journal of the European Patent Office, No. 12/82

34

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007149348 A